# EUROPEAN PATENT SPECIFICATION

(11) **EP 3 637 393 B1**
(45) Date of publication and mention of the grant of the patent: **06.11.2024**
(21) Application number: 17912493.8
(22) Date of filing: 31.08.2017
(51) Int. Cl.: G02F 1/1333, G02F 1/1339, G09F 9/30, G06F 1/16, G09F 9/35

(54) **DISPLAY ASSEMBLY**
ANZEIGEANORDNUNG
ENSEMBLE D'AFFICHAGE

(30) Priority: 07.06.2017 KR 20170070858
(43) Date of publication of application: 15.04.2020
(73) Proprietor: LG Electronics Inc., Seoul 07336 (KR)
(72) Inventor: KWAK, Younghun, Seoul 07336 (KR); KIM, Daehong, Seoul 07336 (KR)
(74) Representative: Schornack, Oliver
(86) International application number: PCT/KR2017/009533
(87) International publication number: WO 2018/225895

(56) References cited:
- JP-B1- 5 816 388
- KR-A- 20100 046 478
- KR-A- 20130 048 681
- KR-A- 20140 142 904
- KR-A- 20150 035 241
- KR-B1- 101 446 414
- US-A1- 2015 092 122
- US-A1- 2015 256 658

## Description

### BACKGROUND OF THE DISCLOSURE

### 1. Field of the Disclosure

The present disclosure relates to a display assembly, and one particular implementation relates to a display assembly having a wall structure, capable of effectively bonding a display on a curved cover and reducing or avoiding overflow of adhesive material. The present disclosure further relates to a vehicle having such a display assembly.

### 2. Background of the Related Art

An optical bonding process is used as a method of attaching the displays on the cover. The optical bonding process is a method of bonding the cover and the displays using an optical adhesive material. Such process, however, eliminates empty spaces between the cover and the displays, thereby lowering light reflectance of a display assembly.

The optical adhesive material is Optical Clear Resin (OCR) and Optical Clear Adhesive (OCA), for example. The optical adhesive material has a refractive index equivalent to that of a member with which the cover or the display is brought into contact, thereby lowering light reflectance at a boundary between the optical adhesive material and the member.

As another method of attaching the displays on the cover is an air gap method. According to this method, empty spaces are formed between the cover and the displays, and thus external light is reflected at a boundary between the cover and the corresponding empty space and even at a boundary between the display and the empty space. Therefore, the optical bonding process is mainly used in modern display devices requiring high resolution, high visibility and slim thickness, owing to higher visibility than the air gap method.

Upon the optical bonding process, an OCR of a liquid phase may be used as the optical adhesive material. In this case, a method is used in which a resin dam is formed along an edge of a surface, to which the display is attached, in order to evenly apply the liquid OCR on the surface.

In the method of forming the resin dam, liquid resin is coated on the cover and cured to form a dam shape, and adhesive resin is applied to an inside of the formed resin dam. It is possible to form a resin dam having a desired shape based on an amount of spreading of the liquid resin and an amount of deformation of the liquid resin under specific conditions.

For instance, JP 5 816388 B1 relates to adhering two workpieces to one another, wherein one workpiece is curved, such as adhering a touch panel and a curved display device or an LCD module and a curved cover glass and touch panel. In a first step, a first adhesive is disposed in the recesses of a mould (die), the curved workpiece is set onto the mould and the first adhesive is at least pre-cured, so that the first adhesive forms protrusions on the curved workpiece, wherein the outermost protrusions have a greater height forming a dam portion. The space between the dam portions is filled with a second adhesive, onto which the second workpiece is placed and adhered to the first workpiece during curing of the second adhesive.

However, in the case of attaching a display on a curved cover, it is difficult to form a resin dam in a uniform thickness or the like using liquid resin according to a curvature of the cover, which may cause a problem of lowering quality of a display assembly.

### SUMMARY OF THE DISCLOSURE

The related art has a problem that an optical adhesive material coated for attaching a display is not evenly coated on a curved cover when the display is attached on the curved cover.

The related art has a problem that a liquid optical adhesive material flows over an adhered portion, to which a display is attached (adhered, bonded), due to a tolerance generated during a manufacturing process, and thereby flows into another member.

The related art has a problem that bubbles remain in an adhered portion between a display and a cover when attaching the display.

It is an object of the present invention to avoid the problems of the related Art.

This object is solved by the present invention as defined in the independent claims.

Preferred embodiments are defined by the dependent claims.

According to aspects to better understand the present disclosure, one or more of the following effects can be provided.

First, by including a wall structure, according to the present invention, disposed on a cover and extending long along a side surface of an adhesive layer with one surface in contact with a curved region and another surface in contact with the side surface of the adhesive layer, an optical adhesive material coated to attach a display can be evenly applied onto the curved cover.

Second, by including a wall structure, according to the present invention, which is provided with an inner wall having one surface in contact with the side surface of the adhesive layer, and an outer wall disposed between the inner wall and an edge of the cover, an overflow of the liquid optical adhesive material due to a manufacturing tolerance can be prevented.

Third, by including a wall structure, according to the present invention, which is provided with a protrusion protruding from a surface thereof in contact with the adhesive layer toward a center of the adhesive layer and extending in a direction in which the wall structure extends, a display and a cover can be effectively attached to each other while reducing an amount of an optical adhesive material used during an optical bonding process.

Fourth, by including an exemplary wall structure, which is provided with a venting passage penetrating through a surface of the wall structure in contact with the adhesive layer and an opposite surface to the surface, and having a shape bent at least once, bubbles in an adhered portion of a display can be effectively discharged to outside of the adhered portion during a display attaching process.

The effects of the present disclosure are not limited to those effects mentioned above, and other effects not mentioned may be clearly understood by those skilled in the art from the description of the appended claims.

### BRIEF DESCRIPTION OF THE DRAWINGS

FIG. 1 is a planar view of a display assembly, viewed from a top.
FIG. 2 is a rear view of the display assembly of FIG. 1, viewed from a bottom.
FIG. 3 is a lateral view of the display assembly of FIG. 1, viewed from the left.
FIG. 4 is an exploded perspective view of the display assembly of FIG. 1.
FIG. 5 is a cross-sectional view of the display assembly of FIG. 1, taken along the line A-A'.
FIG. 6 is a partial enlarged view of part B of the display assembly of FIG. 5.
FIG. 7 is a partially enlarged view of part C, with removing a display 20 and ah adhesive layer 30 from the display assembly of FIG. 1.
FIG. 8 is a planar view of a left part of a side wall structure 110 of FIG. 6, viewed from a top.
FIG. 9 is a lateral view of the left part of the side wall structure 110 of FIG. 6, viewed from the right.
FIG. 10 is a lateral view of the left part of the side wall structure 110 of FIG. 6, viewed from the left.
FIG. 11 is a cross-sectional view of the left part of the side wall structure 110 of FIG. 8, taken along the line D-D'.
FIG. 12 is a planar view of a front wall structure 120 of FIG. 6, viewed from a top.
FIG. 13 is a rear view of the front wall structure 120 of FIG. 12, viewed from the rear.
FIG. 14 is a front view of the front wall structure 120 of FIG. 12, viewed from the front.
FIG. 15 is a lateral view of the front wall structure 120 of FIG. 12, viewed from the left.

### DETAILED DESCRIPTION OF THE DISCLOSURE

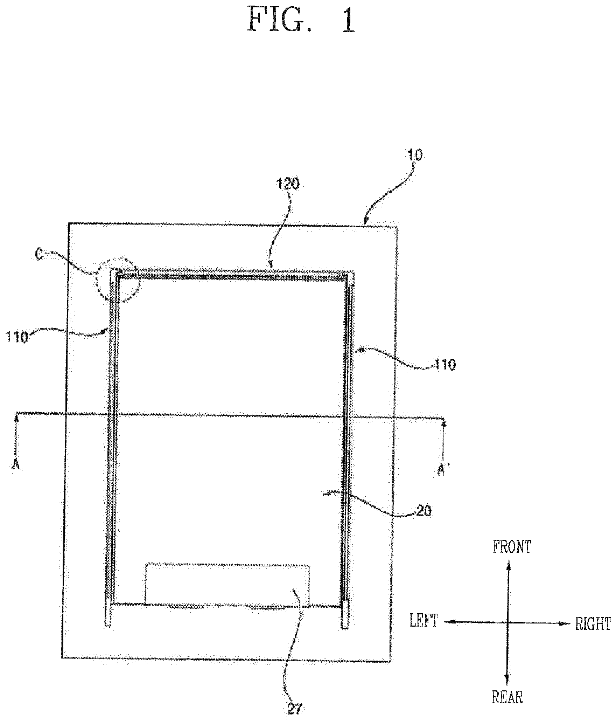

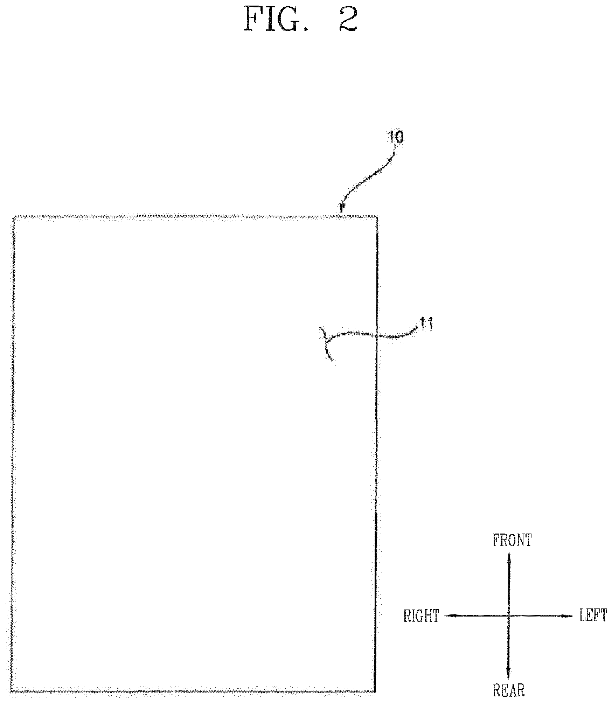

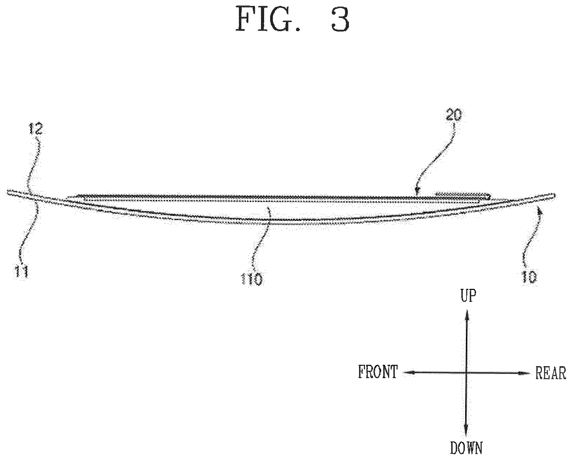

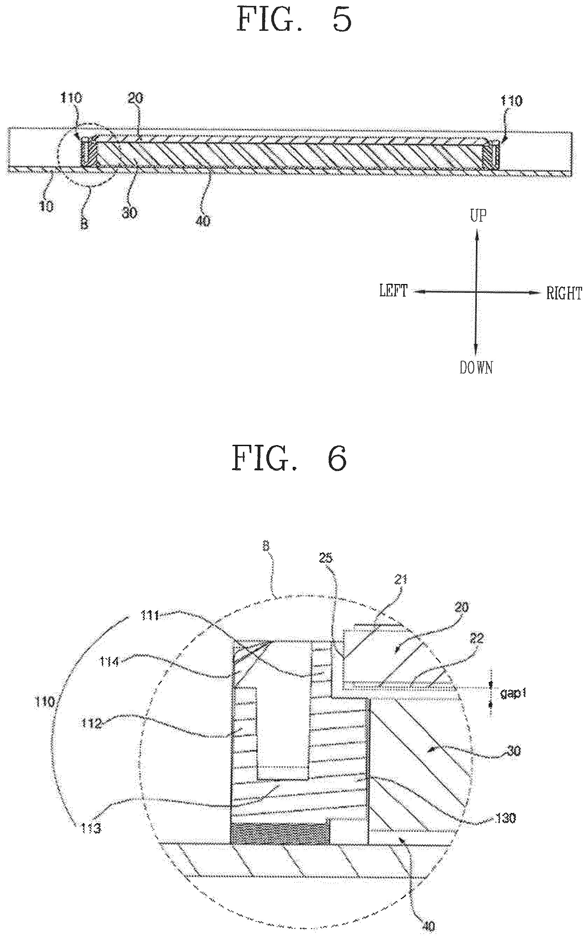

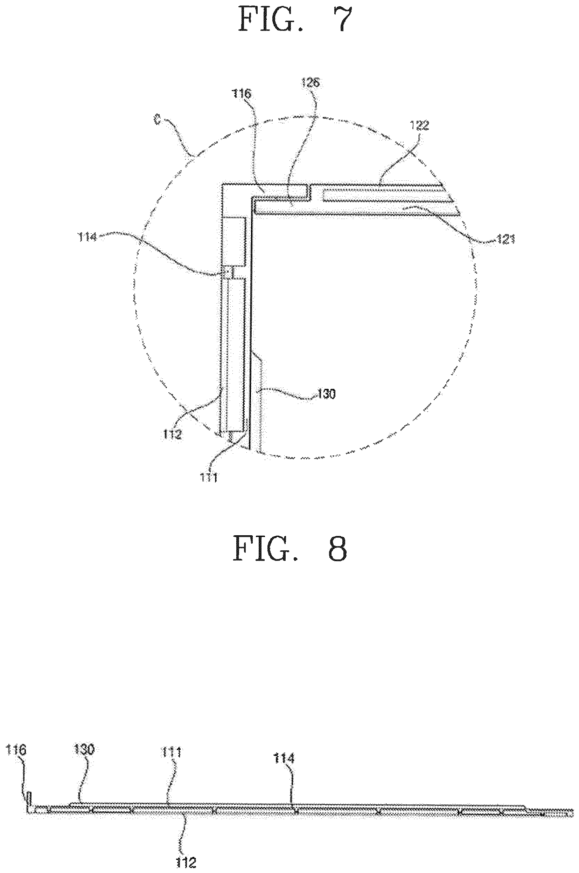

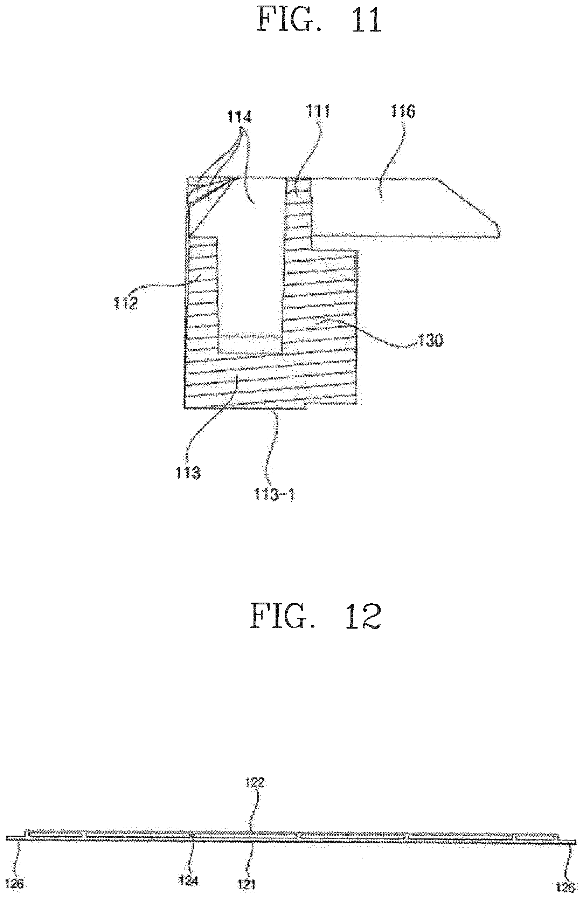

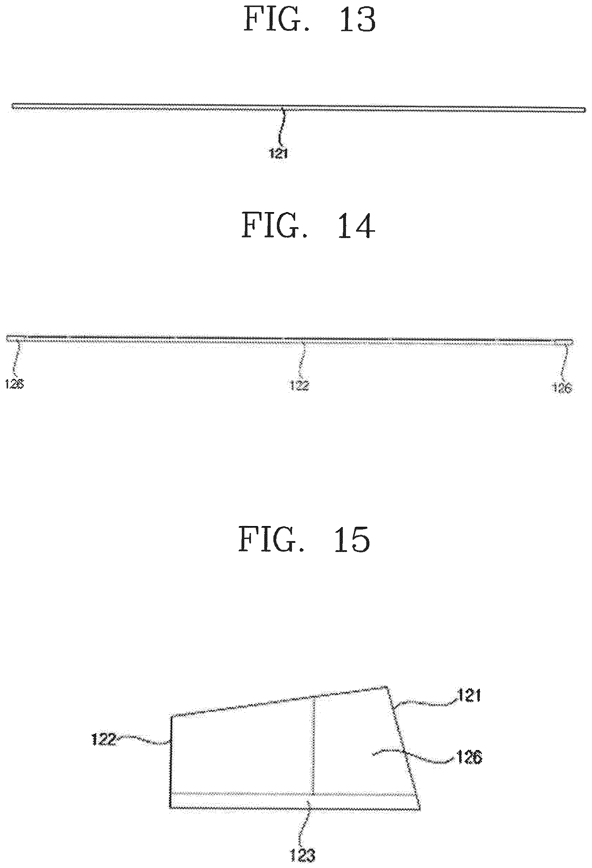

FIGS. 1 and 15 are views illustrating a structure and operation of a display assembly in accordance with one embodiment of the present disclosure. FIGS. 1 to 6 are a planar view, a rear view, a side view, an exploded perspective view, a longitudinal sectional view, and a partially enlarged view of a display assembly according to one embodiment of the present disclosure. FIG. 7 is a partially enlarged view of a part C, with removing a display 20 and an adhesive layer 30 from the display assembly of FIG. 1. FIGS. 8 to 11 are a planar view, a right side view, a left side view, and a longitudinal sectional view, respectively, of a side wall structure 110 of FIG. 6. FIGS. 12 to 15 are a planar view, a rear view, a front view, and a left side view, respectively, of a front wall structure 120 of FIG. 6.

Hereinafter, a display assembly according to the present embodiment will be described with reference to FIG. 1 and the following drawings.

A display assembly according to an embodiment of the present disclosure includes a cover 10 having a curved surface formed to be bent. The display assembly includes a display 20 disposed on the curved surface. The display assembly includes an adhesive layer 30 disposed between the cover 10 and the display 20. The display assembly includes a wall structure 100. The wall structure 100 is disposed on the cover 10. The wall structure 100 has one surface brought into contact with the curved surface and another surface brought into contact with a side surface of the adhesive layer 30. The wall structure 100 extends along the side surface of the adhesive layer 30.

Referring to FIGS. 8 to 11, the cover 10 is formed into a substantially rectangular plate shape. The cover 10 may be partially or wholly formed to be transparent, semitransparent or opaque. The semitransparent or transparent portion of the cover 10 may be provided with an opaque sheet or the like on its upper surface to protect internal members from external light.

The cover 10 may be wholly or partially formed of a light-transmitting material. At least part of the cover 10 is formed as a light-transmissive portion so that external light can be transmitted to the inside of the cover 10. At least part of the cover 10 is formed as a light-transmissive portion so that light emitted from the display 20 can be discharged to the outside through the cover 10. When viewed from a bottom of the cover 10, an active area which is a light-emitted portion of the display 20 is wider than the light-transmissive portion of the cover 10, so that light emitted from the display 20 can be discharged to outside through the cover 10.

The cover 10 may be formed to be concave, convex or bent into different shapes when viewed from above. The cover 10 is integrally formed so that a bent or curved portion and a flat portion are continuously connected to each other, which may result in obtaining structural rigidity and improving appearance of the cover 10.

The cover 10 may be provided with at least one surface formed to be curved or flat. The display assembly may be provided with a plurality of displays 20 arranged on the at least one surface.

In one embodiment of the present disclosure, the cover 10 is formed in a curved shape which is downwardly convex as a whole. The cover 10 is provided with a lower surface 11 which is curved to be downwardly convex. The cover 10 is provided with an upper surface 12 which is curved to be downwardly convex. The upper surface 12 of the cover 10 is curved to be downwardly concave when viewed from above.

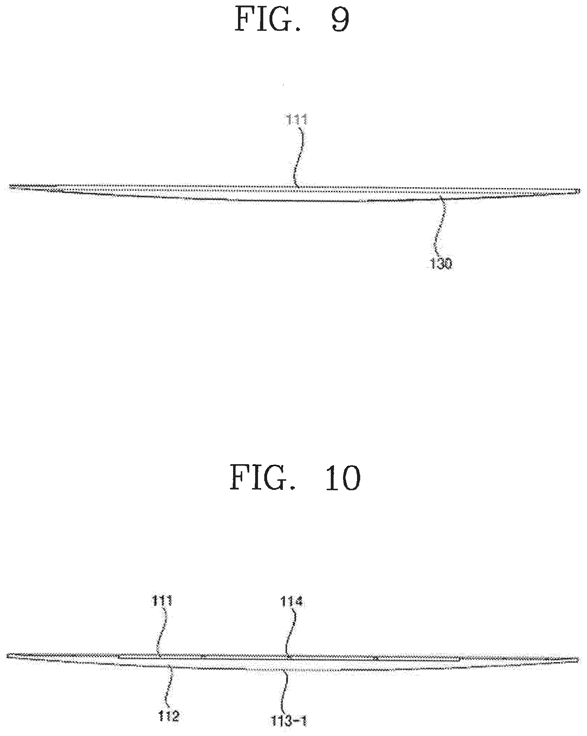

Referring to FIGS. 10 and 11, the upper surface 12 of the cover 10 includes an adhesion surface which is not curved or bent in a left-right direction and is curved in a front-rear direction. The display 20 is attached to the adhesion surface. The cover 10 may be formed such that a surface extending from the edge of the attachment surface of the display 20 to the edge of the cover 10 is inclined downward toward the center of the cover 10.

The cover 10 may be provided with a coupling member for coupling the cover 10 to a main body to which the cover 10 is attached. The coupling member includes at least one of a protrusion, a ring, a bolt coupling portion, and the like. The coupling member may include a coupling ring which is hooked to the main body. The coupling member may include a cover coupling portion that is coupled to the main body in a bolt-nut coupling manner.

The cover 10 may be provided with a guide member for guiding a coupling position with the main body to which the cover 10 is coupled.

The cover 10 may be provided with a cover wall structure on a rear side. The cover wall structure may be connected to side wall structures 110 to form a space in which the adhesive layer 30 is received. The cover wall structure can prevent a liquid adhesive material from flowing to the rear when adhering the display 20.

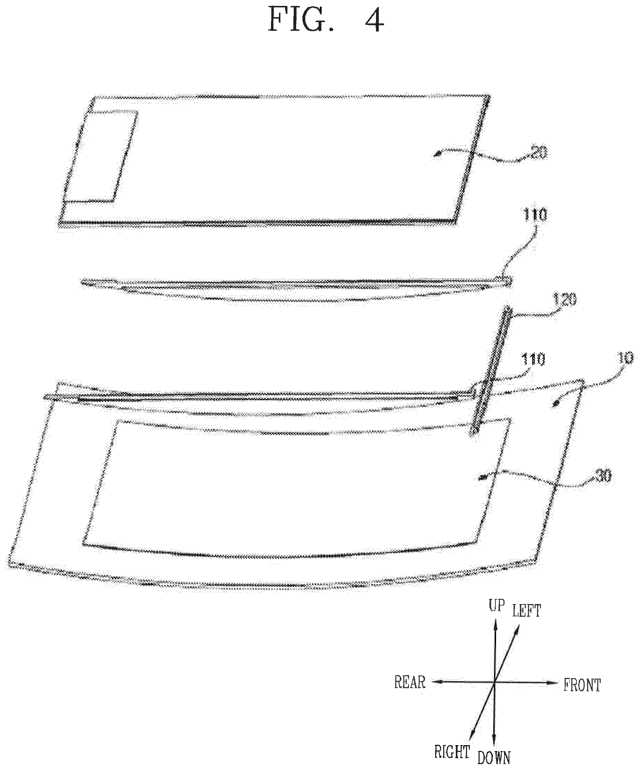

The display 20 is a curved display. The display 20 may be formed in a shape having a constant thickness or having a portion with a different thickness. The display 20 may be formed in a circular or polygonal shape. Referring to FIG. 4, in this embodiment, the display 20 is formed in a rectangular plate shape. The display 20 is formed as a plane having a constant thickness. The display 20 is provided, at an edge thereof, a portion whose thickness is made thinner than a central portion by a predetermined length.

The embodiment of the present disclosure illustrates an LCD as the display 20, but the present disclosure is not limited to this. The display 20 may alternatively be implemented by a different type, such as Light Emitting Diode (LED), Organic Light Emitting Diode (OLED), and the like.

The display 20 emits light by itself or by a backlight and performs the function as the display 20. In this embodiment, a backlight (not shown) is disposed on an upper side of the display 20.

The display 20 is disposed on an upper side of the cover 10. The display 20 is disposed on the upper surface 12 of the cover 10. The display 20 is attached on the upper surface 12 of the cover 10. The display 20 is attached on the cover 10. The display 20 is attached on the upper surface 12 of the cover 10 by an adhesive layer 30. The adhesive layer 30 is formed by curing a liquid adhesive material.

The display 20 is disposed with being spaced apart from the upper surface 12 of the cover 10 by a predetermined distance. A distance between the display 20 and the lowest point of the upper surface 12 of the cover 10 may vary depending on a curvature of the upper surface 12 of the cover 10. The distance between the display 20 and the lowest point of the upper surface 12 may vary depending on a curvature of the display 20.

The display 20 may be attached from one side on the cover top surface 12 in a state of being tilted to the one side in the process of being adhered onto the upper surface 12 of the cover 10. In this embodiment, the display 20 is attached from the front side in a state of being tilted to the front when it is attached on the cover top surface 12. This embodiment is effective in the case where the display 20 is attached from the left side in a state of being tilted to the front.

A wall structure 100 is disposed in order to prevent the liquid adhesive material from flowing toward edges of the cover 10 from a portion, at which the display 20 is attached on the cover top surface 12, into other members during attachment of the display 20. The wall structure 100 will be described later.

Referring to FIGS. 12 and 13, in an embodiment of the present disclosure, the display 20 is disposed so as not to be in contact with other members of the display assembly, such as the cover 10 or the wall structure 100, in addition to the adhesive layer 30. In the case where the display 20 is disposed in contact with another member having a fixed shape, when there is manufacturing tolerance, a contact surface between the display 20 and the another member is not constant, and thereby stress or deformation may occur. The display 20 is disposed on the adhesive layer 30 to prevent generation of stress or deformation, caused due to a contact with other members. When a distance between the display 20 and another member such as the cover 10, the wall structure 100 and the like is not constant due to manufacturing tolerances, the adhesive layer 30 also acts to buffer it.

In another embodiment of the present disclosure, the display 20 is disposed in contact with an upper end of the wall structure 100. The display 20 may be bonded or attached on the upper end of the wall structure 100 in a placed state. The display 20 may be bonded to the cover in a state where the display 20 is first coupled with a backlight or the like. At this time, it may be effective that the display 20 is disposed in contact with the upper end of the wall structure 100 and attached thereto.

A backlight is disposed on an upper side of the display 20. The backlight is attached on a display upper surface 21. The backlight may be an LED backlight or other light source.

A display bottom surface 22 may be formed to be flat or curved depending on the type of the display 20. In this embodiment, the display 20 is a flat display and the display bottom surface 22 is also formed flat. The display bottom surface 22 is disposed to be spaced apart from a wall structure protrusion 130 by a predetermined distance in a perpendicular direction.

The display bottom surface 22 includes an active region and an inactive region. The active region emits light by itself or by a backlight disposed on the display top surface 21.

The display bottom surface 22 is disposed with being spaced apart from the cover top surface 12 by a predetermined distance. The distance between the display bottom surface 22 and the cover top surface 12 may vary depending on a curvature of the cover top surface 12.

The active region may be formed to be flat or curved depending on the type of the display 20. In this embodiment, the display 20 is a flat display and the active region is also formed flat. The active region emits light by itself or by a backlight disposed on the display top surface 21. The active region performs the function of the display 20. The light emitted from the active region passes through the light-transmissive portion of the cover 10 and is discharged outside the cover 10.

The inactive region is disposed around the active region. The inactive region does not emit light. A portion of the cover 10 where the inactive region is disposed may be formed opaque so that the inactive region is not visible to the user. The cover 10 may be provided with an opaque sheet or the like attached on a portion of the cover top surface 12 so that the inactive region is not visible to the user.

A display front surface is disposed adjacent to a front wall structure 120. The display front surface 23 is disposed to be spaced apart from the front wall structure 120 by a predetermined distance in a perpendicular direction.

A display rear surface is disposed adjacent to a cover rear wall. The display rear surface 24 is disposed with being spaced apart from the cover rear wall 18 by a predetermined distance.

Both side surfaces 25 of the display 20 are disposed adjacent the side wall structures 110. The both side surfaces 25 of the display 20 are spaced apart from the side wall structures 110 by predetermined distances in a horizontal direction.

The display 20 includes a display control unit 27 (see FIG. 1). The display control unit 27 is disposed on an upper side of the display 20. The display control unit 27 controls at least one function of the display 20. The display control unit 27 may be connected to a control unit (not shown) of the main body to control the display 20.

The adhesive layer 30 is disposed between the display 20 and the cover 10. The adhesive layer 30 is made of an optical adhesive material. The adhesive layer 30 is formed to be transparent so as to allow light emitted from the display 20 to pass therethrough. The optical adhesive material is Optical Clear Resin (OCR), Optical Clear Adhesive (OCA), or the like. This embodiment is described based on OCR as an optical adhesive material, but may also be applied to the case of using other materials.

The adhesive layer 30 is formed by curing a liquid adhesive material. The adhesive layer 30 obtains a shape in a manner that a liquid adhesive material is cured in contact with the cover 10, the wall structure 100, the display 20, and the like. The adhesive layer 30 is formed to be transparent so as to allow light emitted from the display 20 to pass therethrough. The adhesive layer 30 prevents external light coming through the cover 10 from being reflected on a contact surface between the adhesive layer 30 and the adhesion surface of the display, thereby improving visibility of the display 20.

OCR is applied in a liquid phase, flows along the shapes of the cover, the wall structure and the display, and then is cured. OCR may be applied in a liquid phase and then naturally cured, may be cured by catalysis of ultraviolet rays irradiated, or may be thermally cured, depending on types.

OCR in a general manufacturing process is coated on the cover 10 more than a proper amount, in consideration of manufacturing tolerances, in order to prevent a case where the display 20 is not fully bonded due to the lack of OCR. There is a need for a method of preventing the OCR from flowing over edges of a surface, to which the display 20 is attached on the cover 10, and affecting other members. In the related art, in order to prevent the OCR from flowing over the edges of the surface, to which the display 20 is attached on the cover 10, and affecting other members, a method of applying and curing a dam by using a liquid resin or the like has been used. The related art has a problem that the shape of the dam is not uniform on a curved surface. The wall structure 100 according to the present disclosure is advantageous in that an accommodation space of the OCR can be constantly maintained even on a curved surface owing to a uniform shape of the wall structure 100.

The adhesive layer 30 allows the display 20 to adhere onto the cover 10. The adhesive layer 30 reduces an amount of light, which is reflected before reaching the display 20 after coming into the cover 10 through the light-transmissive portion of the cover. The adhesive layer 30 may be configured to have a refractive index equivalent to that of the light-transmissive portion of the cover. The adhesive layer 30 may be configured to have a refractive index equivalent to that of the display 20. The adhesive layer 30 may lower reflectance at an interface with the cover 10. The adhesive layer 30 may lower reflectance at a contact surface with the display 20. The adhesive layer 30 may improve visibility of the display 20.

The adhesive layer 30 is formed as the OCR is cured in a contact state with the display 20, the cover 10, and the wall structure 100. The OCR may be applied in a liquid phase and then naturally cured, may be cured by catalysis of ultraviolet rays irradiated, or may be thermally cured, depending on types. The OCR is applied in a liquid phase and cured in a state flown along a shape of a surface brought into contact with the cover 10, the wall structure 100, the display 20, etc. to form the adhesive layer 30, thereby providing adhesion force (or bonding force).

The adhesive layer 30 provides adhesion force to the display 20, the cover 10 and the wall structure 100. The adhesive layer 30 allows the display 20 to be placed in non-contact with other members such as the cover 10, the wall structure 100, and the like. The adhesive layer 30 has its shape as a liquid adhesive material is cured in a contact state with the cover 10, the display 20, the wall structure 100 and the like.

The thusly-constructed display assembly has an advantage that the display 20 is prevented from being stressed or deformed due to manufacturing tolerances. The display assembly has an advantage that durability of the display 20 against external impact is improved. The display assembly has an advantage that heat generated in the display 20 and transmitted to the cover 10 is reduced.

The adhesive layer 30 is disposed between the display 20 and the cover 10. The adhesive layer 30 is disposed between the display 20 and the cover top surface 12. The adhesive layer 30 has an upper surface brought into contact with the display bottom surface 22. The adhesive layer 30 has a lower surface brought into contact with the cover bottom surface 12. The adhesive layer 30 has a lower surface brought into contact with a touch sensing portion 40 when the touch sensing portion 40 is further disposed.

The adhesive layer 30 has a side surface brought into contact with the wall structure 100. The adhesive layer 30 is brought into contact with a protrusion 130 of the wall structure 100. The protrusion 130 of the wall structure 100 can increase a contact area between the wall structure 100 and the adhesive layer 30, thereby enhancing durability of the adhesive layer 30 against external impact.

The adhesive layer 30 may also be brought into contact with an adhered portion between the wall structure 100 and the cover 10. Therefore, a material that does not cause inhibition of OCR curing is preferably used as the adhesive material for bonding the wall structure 100 and the cover 10 to each other.

The adhesive layer 30 is brought into close contact with the cover 10 and the touch sensing portion 40 and bonded thereto when the touch sensing portion 40 is disposed, thereby improving adhesive force of the cover 10 and the touch sensing portion 40.

The display assembly may further include a touch sensing portion 40. The touch sensing portion 40 is formed such that a contact surface with the cover 10 is formed curved or flat to correspond to the shape of the cover top surface 12. The touch sensing portion 40 senses the touch of the user. The touch sensing portion 40 can be of a contact sensing type, such as an electrostatic type or a piezoelectric type. In this embodiment, the touch sensing portion 40 is formed in a shape of a rectangular plate having a constant thickness. The touch sensing portion 40 is configured to be transparent. The touch sensing portion 40 is disposed between the cover top surface 12 and the adhesive layer 30 and is attached thereto.

Referring to FIGS. 8, 10 and 13 to 22, the wall structure 100 is formed in a bar-like shape extending along the side surface of the display 20. The wall structure 100 extends on the cover top surface 12. The wall structure 100 may be formed of a transparent or opaque material.

Hereinafter, a direction toward a center of the cover 10 is defined as "inner side" and a direction toward an edge of the cover 10 is defined as "outer side" with respect to the wall structure 100 as a reference.

The wall structure 100 includes wall structure inner walls 111 and 121, wall structure outer walls 112 and 122, wall structure connecting walls 113 and 123 and wall structure connecting ribs 114 and 124. The wall structure 100 has a cross-section in a cup shape when a width direction is cut vertically. The wall structure 100 includes wall structure outer walls 112 and 122 disposed between the wall structure inner walls 111 and 121 and a cover edge. The wall structure 100 is formed as the wall structure inner walls 111 and 121 and the wall structure outer walls 112 and 122 are spaced by a predetermined distance. The wall structure 100 includes an inner space defined by the wall structure inner walls 111 and 121 and wall structure outer walls 112 and 122 and the wall structure connecting walls 113 and 123.

The wall structure 100 may be configured by a plurality of parts. The wall structure 100 may have all or part of a plurality of parts integrally formed with the cover 10. In this embodiment, the wall structure 100 is configured by three parts including a pair of side wall structures 110 and a front wall structure 120. The cover 10 has a cover rear wall 18 formed on a lower side thereof. The cover rear wall 18 has a wall surface which is in contact with the adhesive layer 30. The pair of side wall structures 110 and the cover rear wall 18 are connected to form a space in which the adhesive layer 30 is accommodated.

The pair of side wall structures 110 and the front wall structure 120 are disposed on the cover 10. The pair of side wall structures 110 and the front wall structure 120 are attached on the cover top surface 12. The adhesive layer 30 may also be brought into contact with an adhered portion between the wall structure 100 and the cover 10. Therefore, a material that does not cause inhibition of OCR curing is preferably used as the adhesive material for bonding the wall structure 100 and the cover 10 to each other.

Referring to FIGS. 8 and 14, the pair of side wall structures 110 are provided with a side wall structure coupling protrusion 116 protruding from an upper end thereof toward the front wall structure 120. The side wall structure coupling protrusion 116 forms a 90-degree angle with the side wall structure 110. The front wall structure 120 is provided with front wall structure coupling protrusions 126 formed on both ends thereof to correspond to the side wall structure coupling protrusions 116 of the side walls 110. In the plurality of wall structures 100 constructed as described above, such coupling portions are formed in a staggered (or zig-zag) coupling structure.

The wall structure 100 is provided with a wall structure protrusion 130 formed on an inner surface of the side wall structure 110. The wall structure protrusion 130 is disposed such that an upper end thereof forms an upper gap g1 from the display bottom surface 22. The wall structure protrusion 130 will be described in detail below.

The wall structure 100 includes a venting passage. The venting passage employs a staggered structure, so that air is discharged through the venting passage and the OCR does not flow into the venting passage during adhesion of the display 20. The venting passage penetrates through a surface of the wall structure 100, which is in contact with the adhesive layer, and an opposite surface of the surface. The venting passage penetrates through the wall structure inner walls 111 and 121 and the wall structure outer walls 112 and 122. The venting passage penetrates through an inner surface of the wall structure inner wall 111, 121 and an outer surface of the wall structure outer wall 112, 122. The wall structure 100 is formed such that the venting flow path 140 has a shape bent at least once. The wall structure 100 may have the venting passage which is partially connected and partially separated when viewed in an up-down direction.

The venting passage may be formed in coupling portions of the plurality of wall structures 100. Referring to FIG. 7, in this embodiment, the venting passage is formed at the coupling portion between the side wall structure 110 and the front wall structure 120.

The coupling portion of the plurality of wall structures 100 is formed in the staggered coupling structure as described above, and is adhered on the cover 10 while maintaining a predetermined gap, thereby forming the venting passage. In this manner, the wall structure 100 can prevent the OCR from leaking to the outside of the wall structure 100 while discharging air to the outside of the wall structure 100 through the venting passage when the display 20 is attached. The gap of the venting passage is set in consideration of tolerance of an assembly zig. The gap of the venting passage is set in consideration of viscosity of OCR.

The coupling portion of the plurality of wall structures 100 may form the venting passage in a manner that the plurality of wall structures 100 are partially connected and partially separated.

With the configuration of the display assembly, the OCR is not leaked to outside of the wall structure 100 while discharging air to outside of the wall structure 100 through the venting passage during attachment of the display 20, which may result in effective bonding of the display 20.

The display assembly has an advantage in that air is effectively discharged through the venting passage during attachment of the display 20, by forming the venting passage in a corner portion where the coupling portion of the plurality of wall structures 100 is disposed.

The wall structure 100 is in contact with the side surface of the adhesive layer 30, and thus the side surface of the adhesive layer 130 is uniformly formed. The wall structure 100 prevents an introduction of OCR into other members, thereby lowering a defect rate of the display assembly.

The wall structure 100 accommodates the OCR, which flows over the wall structure inner walls 111 and 121, in the inner space of the wall structure 100 during the attachment of the display 20 so as to prevent the OCR from flowing into other members, and eliminates a process of washing out the OCR flowing over the adhered portion of the display 20 so as to simplify processes.

In the related art, in order to prevent OCR from flowing over edges of a surface, to which the display 20 is attached on the cover 10 and affecting other members, a method of forming a dam by applying and curing a liquid resin has been used. In the related art, the shape of the dam is not constant on a curved surface depending on the shape of the curved surface. As a result, adhesive resin is not uniformly applied to the inside of the dam, which causes unstable quality of the display assembly. On the other hand, the wall structure 100 has a uniform shape and has the OCR evenly applied therein, thereby improving the quality of the display assembly.

The wall structure 100 is provided with the wall structure protrusion 130 to increase the contact area with the adhesive layer 30, which may result in improving durability of the adhesive layer 30 against external impact.

The wall structure 100 is disposed such that a predetermined gap is formed between the wall structure inner walls 111 and 121 and the side surfaces of the display 20 in a horizontal direction, thereby preventing generation of bubbles in a liquid adhesive member by an air-vent function while discharging air between the display 20 and the cover 10 to the outside when attaching the display 20. The wall structure inner walls 111 and 121 will be described in detail below.

The wall structure 100 is disposed on a path through which external light entering the inside of the cover 10 through the light-transmissive portion of the cover 10 moves to other members except for the display assembly, so as to reduce or block influence of the external light. The wall structure 100 has improved appearance because it covers other members when the user views the display 20 at an oblique angle.

The wall structure 100 is disposed on the cover 10. The wall structure 100 is attached on the cover top surface 12. An inner surface of the wall structure 100 is in contact with the side surface of the adhesive layer 30. A lower surface of the wall structure 100 is brought into contact with the cover top surface 12. The wall structure 100 extends while its inner surface is in contact with the side surface of the adhesive layer 30 and its lower surface is in contact with the cover top surface 12. The wall structure 100 extends along the side surface of the adhesive layer 30. The wall structure 100 is disposed side by side with the surfaces 23, 24 and 25 of the display 20.

The wall structure 100 is attached to the cover top surface 12 using an adhesive or the like. The adhesive layer 30 may also be brought into contact with an adhered portion between the wall structure 100 and the cover 10. Therefore, a material that does not cause inhibition of OCR curing is preferably used as the adhesive material for bonding the wall structure 100 and the cover 10 to each other.

The wall structure 100 is disposed such that its upper end is lower than the display top surface 21 and higher than the display bottom surface 22. The wall structure 100 has an upper end disposed between the top and bottom surfaces of the display.

The wall structure 100 may be disposed so that the upper end thereof is perpendicularly closer to the display top surface 21 than to the display bottom surface 22. The thusly-constructed display assembly has an advantage that its appearance is improved as the wall structure 100 obscures other members inside the cover 10 when the user views the display 20 at an oblique angle.

The wall structure 100 may be formed to be fit into a pre-formed structure of the cover 10.

The pair of side wall structures 110 are formed in a plane symmetrical shape. The pair of side wall structures 110 are formed in a bar-like shape extending in a front-rear direction. The pair of side wall structures 110 are formed in a bar-like shape extending along the side surfaces 23, 24 and 25 of the display 20.

The pair of side wall structures 110 are provided with a side wall structure coupling protrusion 116 protruding from its upper end toward the front wall structure 120. The side wall structure coupling protrusion 116 forms a 90-degree angle with the side wall structure 110. The front wall structure 120 is provided with front wall structure coupling protrusions 126 formed on both ends thereof to correspond to the side wall structure coupling protrusions 116 of the side wall structures 110. The thusly-constructed plurality of wall structures 100 has a coupling portion in a zig-zag (staggered) coupling structure in which the side wall structure coupling protrusion 116 and the wall structure coupling protrusion 126 are engaged with each other in the zig-zag form.

The plurality of wall structures 100 are provided with a venting passage in the coupling portion. The coupling portion between the plurality of wall structures 100 is formed in the zig-zag (staggered) coupling structure as described above, and is adhered on the cover 10 while maintaining a predetermined gap, thereby forming the venting passage. In this manner, the wall structure 100 can prevent the OCR from leaking to the outside of the wall structure 100 while discharging air to the outside of the wall structure 100 through the venting passage when the display 20 is attached.

Each of the pair of side wall structures 110 includes a side wall structure inner wall 111. The side wall structure 110 includes a side wall structure outer wall 112. The side wall structure 110 includes a side wall structure connecting wall 113. The side wall structure 110 includes a side wall structure connecting rib 114.

The side wall structure inner wall 111 is formed in a bar-like shape extending along the side surfaces 23, 24 and 25 of the display 20. The side wall structure inner wall 111 is formed to have a constant thickness. The side wall structure inner wall 111 may be formed such that its lower side is thicker than its upper side to reinforce rigidity.

The side wall structure inner wall 111 is formed such that its upper surface is flat. The side wall structure inner wall 111 has a rounded top corner so that the liquid OCR flows toward the wall structure 100 without flowing toward the display top surface 21 when the liquid OCR overflows during the adhesion of the display 20.

The side wall structure inner wall 111 is connected to the side wall structure outer wall 112 by the side wall structure connecting wall 113 and the side wall structure connecting rib 114. The lower end of the side wall structure inner wall 111 is connected to the lower end of the side wall structure outer wall 112 by the side wall structure connecting wall 113. The side wall structure inner wall 111 forms an inner space of the side wall structure together with the side wall structure outer wall 112 and the side wall structure connecting wall 113.

The side wall structure inner wall 111 is disposed such that its upper end is lower than the display top surface 21 and higher than the display bottom surface 22. The side wall structure 110 has an upper end disposed between the display top surface 21 and the display bottom surface 22.

The side wall structure 111 may be disposed so that the upper end thereof is perpendicularly closer to the display top surface 21 than to the display bottom surface 22. The thusly-constructed display assembly has an advantage that its appearance is improved as the wall structure 100 obscures other members inside the cover 10 when the user views the display 20 at an oblique angle.

The side wall structure outer wall 112 may be formed in a bar-like shape extending along the side surfaces 23, 24 and 25 of the display 20 and may have substantially the same shape as the side wall structure inner wall 111. The side wall structure outer wall 112 is formed to have a predetermined thickness. The side wall structure outer wall 112 may be formed such that its lower side is thicker than its upper side to reinforce rigidity.

The side wall structure outer wall 112 is formed such that the upper surface is flat.

The side wall structure outer wall 112 is connected to the side wall structure inner wall 111 by the side wall structure connecting wall 113 and the side wall structure connecting rib 114. The lower end of the side wall structure outer wall 112 is connected to the lower end of the side wall structure inner wall 111 by the side wall structure connecting wall 113. The side wall structure outer wall 112 forms an inner space of the side wall structure together with the side wall structure inner wall 111 and the side wall structure connecting wall 113.

The side wall structure outer wall 112 may be formed such that its upper end is lower than the side wall structure inner wall 111. The side wall structure outer wall 112 may be formed to have a height in inverse proportion to a distance between the side wall structure inner wall 111 and the side wall structure outer wall 112 and may be formed to maintain a volume of the inner space of the side wall structure 110.

A lower surface of the side wall structure connecting wall 113 is brought into contact with the cover top surface 12. The side wall structure connecting wall 113 is formed to be curved in correspondence with the curvature of the cover top surface 12 so that the lower surface thereof is in contact with the cover top surface 12. The side wall structure connecting wall 113 is attached to the cover top surface 12 using an adhesive or the like. The adhesive layer 30 may also be brought into contact with an adhered portion between the wall structure 100 and the cover 10. Therefore, a material that does not cause inhibition of OCR curing is preferably used as the adhesive material for bonding the side wall structure connecting wall 113 and the cover 10 to each other.

The side wall structure connecting wall 113 is formed in a bar-like shape extending in a direction in which the side wall structure inner wall 111 and the side wall structure outer wall 112 extend. The side wall structure connecting wall 113 connects the lower end of the side wall structure inner wall 111 and the lower end of the side wall structure outer wall 112.

The side wall structure connecting wall 113 forms an inner space of the side wall structure 110 together with the side wall structure inner wall 111 and the side wall structure outer wall 112. In another embodiment of the present disclosure, the side wall structure 110 does not include the side wall structure connecting wall 113. In this case, the cover top surface 12 forms the inner space of the side wall structure 110, instead of the connecting wall, together with the side wall structure inner wall 111 and the side wall structure outer wall 112. The side wall structure inner wall 111 and the side wall structure outer wall 112 may be connected by ribs.

Side wall structure connecting ribs 114 are formed to have a predetermined thickness. The side wall structure connecting ribs 114 connect the side wall structure inner wall 111 and the side wall structure outer wall 112. The side wall structure connecting ribs 114 are arranged such that a plurality of ribs in a low height portion of the side wall structure 110 are arranged closer to one another than a plurality of ribs in a high height portion, thereby reinforcing rigidity of the side wall structure 110.

The side wall structure connecting ribs 114 may be formed such that an upper surface thereof is formed flat to connect the upper end of the side wall structure inner wall 111 and the upper end of the outer wall 112. The side wall structure connecting ribs 114 may be formed such that the upper surface thereof has the same height as the upper end of the side wall structure inner wall 111. The side wall structure connecting ribs 114 may be formed to have a portion, which has the same height as the upper end of the side wall structure inner wall 11, and to be downwardly inclined.

The side wall structure 110 includes a wall structure protrusion 130. The side wall structure 110 is provided with the wall structure protrusion 130 on the inner surface thereof in contact with the adhesive layer 30. The wall structure protrusion 130 protrudes toward the center of the adhesive layer 30. The wall structure protrusion 130 extends in a direction in which the side wall structure 110 extends.

The wall structure protrusion 130 has a rectangular cross section. The wall structure protrusion 130 is formed such that its upper surface corresponds to the display bottom surface. In this embodiment, the display 20 has the display bottom surface 22 in the flat shape, and the wall structure protrusion 130 also has an upper surface in the flat shape.

The wall structure protrusion 130 has a lower surface which is curved to correspond to a curved lower surface of the side wall structure connecting wall 113. The wall structure protrusion 130 is formed higher than the lower surface of the side wall structure connecting wall 113 by a predetermined length, but is not limited thereto. The wall structure protrusion 130 may alternatively be formed to be connected to the lower surface of the side wall structure connecting wall 113. The side wall structure 110 may be configured such that the side wall structure connecting wall 113 and the lower surface of the wall structure protrusion 130 are brought into contact with the cover top surface 12.

The wall structure protrusion 130 may have a lower surface which is formed straight to be positioned at a predetermined distance from the upper end of the side wall structure inner wall 111, irrespective of the shape of the lower surface of the side wall structure connecting wall 113.

The wall structure protrusion 130 is formed to be spaced apart from one end of the side wall structure 110 by a predetermined distance. The wall structure protrusion 130 is formed to be spaced apart from a front end of the side wall structure 110 by a predetermined distance. The wall structure protrusion 130 is formed to be spaced apart from a rear end of the side wall structure 110 by a predetermined distance. The wall structure protrusion 130 is formed to be spaced apart from the coupling portion between the side wall structure 110 and the front wall structure 120 by a predetermined distance. The wall structure protrusion 130 is formed to be spaced apart in a horizontal direction from a corner, at which the upper surface and a left surface of the display meet, by a predetermined distance.

In some cases, the display 20 is attached in a state of being tilted to one side for effective attachment during a manufacturing process of attaching the display 20 to the cover 10. The wall structure protrusion 130 constructed as described above allows the OCR of the liquid phase to smoothly flow in a front-rear direction that the wall structure protrusion extends when the display is attached with being tilted to the front, which may provide an advantage of reducing the liquid OCR flowing over the side wall structure inner wall 111.

The wall structure protrusion 130 allows the OCR of the liquid phase to be effectively coated on the cover top surface 12 to which the display 20 is attached, so that the display 20 can be effectively attached to the cover 10.

The wall structure protrusion 130 is advantageously formed easier than a protrusion formed from an end of the side wall structure 110 in the front-rear direction in a manufacturing process.

The wall structure protrusion 130 is formed such that its end is inclined by a predetermined angle toward the center of the protrusion when viewed from above. The wall structure protrusion 130 is formed in a trapezoidal shape when viewed from above. The wall structure protrusion 130 may have a rounded edge. The thusly-constructed wall structure protrusion 130 can allow the OCR of the liquid phase to smoothly flow along the side wall structure 110, so that the display 20 can be effectively adhered to the cover 10.

The wall structure protrusion 130 may be provided with a plurality of protruding portions. The wall structure protrusion 130 may be provided with a plurality of protruding portions on each of the side wall structures 110. The wall structure protrusion 130 may be provided with a plurality of protruding portions spaced apart from each other at a predetermined interval in the front-rear direction when viewed from above. The wall structure protrusion 130 may be provided with a plurality of protruding portions spaced apart from each other at a predetermined interval in an up-down direction when viewing the side wall structure 110 from inside.

The wall structure protrusion 130 can increase a contact area between the side wall structure 110 and the adhesive layer 30, thereby improving durability of the adhesive layer 30 against external impact and vibration.

The wall structure protrusion 130 has an advantage of reducing an amount of expensive OCR used to form the adhesive layer 30.

The wall structure protrusion 130 is disposed such that an upper end thereof forms an upper gap gap1 from the bottom surface of the display 20. The upper gap gap1 is set in consideration of tolerance of an assembly zig. The upper gap gap1 is set in consideration of viscosity of the liquid OCR. The display 20 has the bottom surface forming the upper gap gap1 with the upper end of the wall structure protrusion 130, and is adhered on the cover 10.

The wall structure protrusion 130 configured as described above allows air between the cover 10 and the display 20 to be discharged to the outside and prevents the liquid OCR from flowing to the outside through the upper gap gap1 when the display 20 is attached, so that the display 20 can be effectively adhered to the cover 10.

The wall structure protrusion 130 has an inner end located outside rather than the active region of the display 20. The wall structure protrusion 130 may have an inner end located outside rather than the light-transmissive portion of the cover, so that light emitted from the display 20 can be effectively emitted to the outside through the light-transmissive portion of the cover. The wall structure protrusion 130 may cause light emitted from the display 20 to go outside through the light-transmissive portion of the cover without being interfered with the wall structure protrusion 130.

The wall structure protrusion 130 may be disposed such that an inner end thereof is spaced apart horizontally from the active region of the display 20 by a predetermined distance. The wall structure protrusion 130 may be disposed such that the inner end thereof is spaced apart horizontally from the light-transmissive portion of the cover by a predetermined distance. The wall structure protrusion 130 having the above-described structure can make the user to see the display 20 well even when the user views the bottom surface of the cover 10 at an oblique angle. The wall structure protrusion 130 can prevent the user from feeling a sense of difference even when the user views the cover bottom surface at an oblique angle.

Referring to FIG. 6, a part of the display 20 is disposed on a straight line which connects an inner edge of the upper end of the wall structure protrusion 130 and an inner edge of the upper end of the side wall structure inner wall 111. The side wall structure 110 having such a structure is advantageous in protecting other members disposed on the cover 10 or inside the main body 10 to which the cover 10 is attached from external direct ray of light. The side wall structure 110 is advantageous in preventing members disposed on the cover or inside the main body to which the cover 10 is attached from being visible by the user, thereby improving appearance.

The wall structure 100 includes a front wall structure 120. The front wall structure 120 is formed in a bar-like shape extending in a left-right direction. The front wall structure 120 extends to the left and right. The front wall structure 120 is formed in a bar-like shape extending along the side surfaces of the display 20. The front wall structure 120 is formed such that its lower surface is in contact with the cover top surface 12. In this embodiment, the cover top surface 12 is formed such that an adhesion surface to which the display 20 is attached is formed in a shape which is not curved in the left-right direction, and the front wall structure 120 is formed such that the lower surface is flat to correspond to the cover top surface 12.

The front wall structure 120 is provided with front wall structure coupling protrusions 126 protruding from both left and right ends toward the side wall structure 110. The front wall structure 120 is provided with front wall structure coupling protrusions 126 formed to correspond to the side wall structure coupling protrusions 116. The front wall structure coupling protrusions 126 form a 90-degree angle with the front wall structure 120. The thusly-constructed plurality of wall structures 100 has a coupling portion in a zig-zag coupling structure in which the side wall structure coupling protrusion 116 and the wall structure coupling protrusion 126 are engaged with each other in a zig-zag form.

The front wall structure 120 includes a front wall structure inner wall 121. The front wall structure 120 includes a front wall structure outer wall 122. The front wall structure 120 includes a front wall structure connecting wall 123. The front wall structure 120 includes front wall structure connecting ribs 124.

The front wall structure 120 is formed such that its inner surface is inclined outward by a predetermined angle, so that the liquid OCR can smoothly flow when the display 20 is attached.

The front wall structure inner wall 121 is formed in a bar-like shape extending along the side surfaces 23, 24 and 25 of the display 20. The front wall structure inner wall 121 is formed to have a constant thickness. The front wall structure inner wall 121 may be formed such that its lower side is thicker than its upper side to reinforce rigidity.

The front wall structure inner wall 121 is formed such that its upper surface is flat. The front wall structure inner wall 121 has a rounded top edge so that the liquid OCR flows toward the wall structure 100 without flowing toward the display top surface 21 when the liquid OCR overflows during the adhesion of the display 20.

The front wall structure inner wall 121 is connected to the front wall structure outer wall 122 by the front wall structure connecting wall 123 and the front wall structure connecting rib 124. The lower end of the front wall structure inner wall 121 is connected to the lower end of the front wall structure outer wall 122 by the front wall structure connecting wall 123. The front wall structure inner wall 121 forms an inner space of the front wall structure together with the front wall structure outer wall 122 and the front wall structure connecting wall 123.

The front wall structure inner wall 121 is formed such that its inner surface is inclined outward by a predetermined angle, so that the liquid OCR can smoothly flow when the display 20 is attached.

The front wall structure inner wall 121 is disposed such that its upper end is lower than the display top surface 21 and higher than the display bottom surface 22. The front wall structure 120 has an upper end disposed between the display top surface 21 and the display bottom surface 22.

The front wall structure inner wall 121 may be disposed so that the upper end thereof is perpendicularly closer to the display top surface 21 than to the display bottom surface 22. The thusly-constructed display assembly has an advantage that its appearance is improved as the wall structure 100 obscures other members inside the cover 10 when the user views the display 20 at an oblique angle.

The front wall structure outer wall 122 may be formed in a bar-like shape elongated along the side surfaces of the display 20 and may be formed in the same or similar shape as the front wall structure inner wall 121. The front wall structure outer wall 122 is formed to have a predetermined thickness. The front wall structure outer wall 122 may be formed such that its lower side is thicker than its upper side to reinforce rigidity.

The front wall structure outer wall 122 is formed such that its upper surface is flat.

The front wall structure outer wall 122 is connected to the front wall structure inner wall 121 by the front wall structure connecting wall 123 and the front wall structure connecting rib 124. The lower end of the front wall structure outer wall 122 is connected to the lower end of the front wall structure inner wall 121 by the front wall structure connecting wall 123. The front wall structure outer wall 122 forms an inner space of the front wall structure together with the front wall structure inner wall 121 and the front wall structure connecting wall 123.

The front wall structure outer wall 122 may be formed such that its upper end is lower than the front wall structure inner wall 121. The front wall structure outer wall 122 may be formed to have a height in inverse proportion to a distance between the front wall structure inner wall 121 and the front wall structure outer wall 122 and may be formed to maintain a volume of the inner space of the front wall structure 120.

A lower surface of the front wall structure connecting wall 123 is brought into contact with the cover top surface 12. The front wall structure connecting wall 123 is formed to correspond to the shape of the cover top surface 12 so that the lower surface thereof is in contact with the cover top surface 12. In this embodiment, the cover top surface 12 is formed such that an adhesion surface to which the display 20 is attached is formed in a shape which is not curved in a left-right direction, and the front wall structure connecting wall 123 is formed such that the lower surface is flat to correspond to the cover top surface 12.

The front wall structure connecting wall 123 is attached to the cover top surface 12 using an adhesive or the like. The adhesive layer 30 may also be brought into contact with an adhered portion between the wall structure 100 and the cover 10. Therefore, a material that does not cause inhibition of OCR curing is preferably used as the adhesive material for bonding the front wall structure connecting wall 123 and the cover 10 to each other.

The front wall structure connecting wall 123 is formed in a bar-like shape extending in a direction in which the front wall structure inner wall 121 and the front wall structure outer wall 122 extend. The front wall structure connecting wall 123 connects the lower end of the front wall structure inner wall 121 and the lower end of the front wall structure outer wall 122.

The front wall structure connecting wall 123 forms an inner space of the front wall structure 120 together with the front wall structure inner wall 121 and the front wall structure outer wall 122. In another embodiment of the present disclosure, the front wall structure 120 does not include the front wall structure connecting wall 123. In this case, the cover top surface 12 forms the inner space of the front wall structure 120, instead of the connecting wall, together with the front wall structure inner wall 121 and the front wall structure outer wall 122. The front wall structure inner wall 121 and the front wall structure outer wall 112 may be connected by ribs.

The front wall structure connecting ribs 124 are formed to have a predetermined thickness. The front wall structure connecting ribs 124 connect the front wall structure inner wall 121 and the front wall structure outer wall 122. The front wall structure connecting ribs 124 are arranged such that a plurality of ribs in a low height portion of the front wall structure 120 are arranged closer to one another than a plurality of ribs in a high height portion, thereby reinforcing rigidity of the front wall structure 120.

The front wall structure connecting ribs 124 may be formed such that an upper surface thereof is formed flat to connect the upper end of the front wall structure inner wall 121 and the upper end of the outer wall 122. The front wall structure connecting ribs 124 may be formed such that the upper surface thereof has the same height as the upper end of the front wall structure inner wall 121. The front wall structure connecting ribs 124 may be formed in a shape of being downwardly bent by a predetermined length so that a height thereof is the same as the upper end of the front wall structure inner wall 121.

## Claims

1. A display assembly comprising:
a cover (10) having a curved surface formed to be bent;
a display (20) disposed on the curved surface of the cover (10);
an adhesive layer (30) disposed between the cover (10) and the display (20); and
a wall structure (100) disposed on the cover (10), and extending along a side surface of the adhesive layer (30) while one surface thereof is in contact with the curved surface of the cover (10) and another surface is in contact with the side surface of the adhesive layer (30),
**characterized in that** the wall structure (100) comprises:
an inner wall (111, 121) having one surface in contact with the side surface of the adhesive layer (30);
an outer wall (112, 122) disposed between the inner wall (111, 121) and an edge of the cover (10); and
a connecting wall (113, 123) connecting the inner wall (111, 121) and the outer wall (112, 122), and
**in that** an inner space is defined by the inner wall (111, 121), the outer wall (112, 122) and the connecting wall (113, 123),
wherein the wall structure (100) is provided with a protrusion (130) protruding toward a center of the adhesive layer (30) from a surface of the inner wall (111, 121) and is in contact with the adhesive layer (30), and
wherein the protrusion (130) is disposed such that an upper end thereof forms an upper gap (gap1) from a bottom surface of the display (20).

2. The display assembly of claim 1, wherein the wall structure (100) is provided as a pair (110) arranged in a bent direction of the curved surface of the cover (10) in a manner of facing each other.

3. The display assembly of claim 1, wherein the wall structure (100) has an upper end disposed between top and bottom surfaces of the display (20).

4. The display assembly of claim 1, wherein the protrusion (130) is spaced a predetermined distance apart from one end of the wall structure (100) in a direction toward a center of the wall structure (100).

5. The display assembly of claim 1, further comprising: a venting passage (140) penetrating through a surface of the wall structure (100), which is in contact with the adhesive layer (30), and an opposite surface of the wall structure (100), and having a shape bent at least once.

6. The display assembly of claim 5, wherein the wall structure (100) comprises a plurality of wall structures (110, 120), and wherein the venting passage (140) is formed in a coupling portion between the plurality of wall structures (110, 120).

7. The display assembly of claim 1, wherein the cover (10) has at least one surface formed to be curved or flat, and
wherein a plurality of displays (20) is arranged on the at least one surface of the cover (10).

8. The display assembly of claim 1, wherein the adhesive layer (30) is disposed to attach the display (20) onto the cover (10), and is formed by curing a liquid adhesive material, and
wherein the wall structure (100) is disposed on the cover (10) between a surface (12) on which the display (20) is disposed and an edge of the cover (10), to form a space in which the liquid adhesive material is accommodated.

9. The display assembly of claim 8, wherein the wall structure (100) accommodates therein liquid adhesive material flowing over a portion of the wall structure (100) during adhesion of the display (20).

10. A vehicle comprising the display assembly according to any one of claims 1 to 9.

## Patentansprüche

1. Anzeigeanordnung, umfassend:
eine Abdeckung (10) mit einer gekrümmten Oberfläche, die gebogen geformt ist;
eine Anzeige (20), die auf der gekrümmten Oberfläche der Abdeckung (10) angeordnet ist;
eine Klebeschicht (30), die zwischen der Abdeckung (10) und der Anzeige (20) angeordnet ist; und
eine Wandstruktur (100), die auf der Abdeckung (10) angeordnet ist und sich entlang einer Seitenfläche der Klebeschicht (30) erstreckt, während eine Oberfläche davon in Kontakt mit der gekrümmten Oberfläche der Abdeckung (10) ist und eine andere Oberfläche in Kontakt mit der Seitenfläche der Klebeschicht (30) ist,
**dadurch gekennzeichnet, dass** die Wandstruktur (100) umfasst:
eine Innenwand (111, 121), die eine Oberfläche in Kontakt mit der Seitenfläche der Klebeschicht (30) stehend aufweist;
eine Außenwand (112, 122), die zwischen der Innenwand (111, 121) und einem Rand der Abdeckung (10) angeordnet ist; und
eine Verbindungswand (113, 123), die die Innenwand (111, 121) und die Außenwand (112, 122) verbindet, und
dass ein Innenraum durch die Innenwand (111, 121), die Außenwand (112, 122) und die Verbindungswand (113, 123) begrenzt wird,
wobei die Wandstruktur (100) mit einem Vorsprung (130) versehen ist, der in Richtung eines Zentrums der Klebeschicht (30) von einer Oberfläche der Innenwand (111, 121) vorsteht und in Kontakt mit der Klebeschicht (30) ist, und
wobei der Vorsprung (130) so angeordnet ist, dass ein oberes Ende desselben einen oberen Spalt (gap1) von einer Bodenfläche des Displays (20) bildet.

2. Anzeigeanordnung nach Anspruch 1, wobei die Wandstruktur (100) als ein Paar (110) vorgesehen ist, das in einer gebogenen Richtung der gekrümmten Oberfläche der Abdeckung (10) so angeordnet ist, dass es einander gegenüberliegt.

3. Anzeigeanordnung nach Anspruch 1, wobei die Wandstruktur (100) ein oberes Ende aufweist, das zwischen der oberen und der unteren Fläche der Anzeige (20) angeordnet ist.

4. Anzeigeanordnung nach Anspruch 1, wobei der Vorsprung (130) in einem vorbestimmten Abstand von einem Ende der Wandstruktur (100) in einer Richtung zum Zentrum der Wandstruktur (100) beabstandet ist.

5. Anzeigeanordnung nach Anspruch 1, ferner umfassend:
einen Entlüftungsdurchgang (140), der durch eine Oberfläche der Wandstruktur (100), die mit der Klebeschicht (30) in Kontakt ist, und eine gegenüberliegende Oberfläche der Wandstruktur (100) hindurchgeht und eine mindestens einmal gebogene Form aufweist.

6. Anzeigeanordnung nach Anspruch 5, wobei die Wandstruktur (100) eine Mehrzahl von Wandstrukturen (110, 120) umfasst, und wobei der Entlüftungsdurchgang (140) in einem Verbindungsabschnitt zwischen der Mehrzahl von Wandstrukturen (110, 120) ausgebildet ist.

7. Anzeigeanordnung nach Anspruch 1, wobei die Abdeckung (10) mindestens eine gekrümmte oder flache Oberfläche aufweist, und
wobei eine Mehrzahl von Anzeigen (20) auf der mindestens einen Oberfläche der Abdeckung (10) angeordnet ist.

8. Anzeigeanordnung nach Anspruch 1, wobei die Klebeschicht (30) so angeordnet ist, dass sie die Anzeige (20) an der Abdeckung (10) befestigt, und durch Aushärten eines flüssigen Klebematerials gebildet wird, und
wobei die Wandstruktur (100) auf der Abdeckung (10) zwischen einer Oberfläche (12), auf der die Anzeige (20) angeordnet ist, und einem Rand der Abdeckung (10) angeordnet ist, um einen Raum zu bilden, in dem das flüssige Klebematerial untergebracht ist.

9. Anzeigeanordnung nach Anspruch 8, wobei die Wandstruktur (100) darin flüssiges Klebematerial aufnimmt, das während des Aufklebens der Anzeige (20) über einen Teil der Wandstruktur (100) fließt.

10. Fahrzeug mit einer Anzeigevorrichtung nach einem der Ansprüche 1 bis 9.

## Revendications

1. Ensemble d'affichage, comprenant:
un couvercle (10) ayant une surface incurvée formée pour se plier;
un écran (20) disposé sur la surface incurvée du couvercle (10);
une couche adhésive (30) disposée entre le couvercle (10) et l'écran (20); et
une structure de paroi (100) disposée sur le couvercle (10) et s'étendant le long d'une surface latérale de la couche adhésive (30) alors qu'une de ses surfaces est en contact avec la surface incurvée du couvercle (10) et qu'une autre surface est en contact avec la surface latérale de la couche adhésive (30),
**caractérisé en ce que** la structure de paroi (100) comprend:
une paroi intérieure (111, 121) dont une surface est en contact avec la surface latérale de la couche adhésive (30);
une paroi extérieure (112, 122) disposée entre la paroi intérieure (111, 121) et un bord du couvercle (10); et
une paroi de liaison (113, 123) disposée entre la paroi intérieure (111, 121) et la paroi extérieure (112, 122); et
**en ce qu'**un espace intérieur est délimité par la paroi intérieure (111, 121), la paroi extérieure (112, 122) et la paroi de liaison (113, 123),
dans lequel la structure de paroi (100) est pourvue d'une saillie (130) faisant saillie vers un centre de la couche adhésive (30) à partir d'une surface de la paroi intérieure (111, 121) et est en contact avec la couche adhésive (30), et
dans lequel la saillie (130) est disposée de sorte qu'une extrémité supérieure de cette dernière forme un espace supérieur (gap1) à partir d'une surface inférieure de l'écran (20).

2. Ensemble d'affichage selon la revendication 1, dans lequel la structure de paroi (100) se présente sous la forme d'une paire (110) disposée dans le sens de la courbure de la surface incurvée du couvercle (10) de manière à se faire face.

3. Ensemble d'affichage selon la revendication 1, dans lequel la structure de paroi (100) a une extrémité supérieure disposée entre les surfaces supérieure et inférieure de l'écran (20).

4. Ensemble d'affichage selon la revendication 1, dans lequel la saillie (130) est espacée d'une distance prédéterminée d'une extrémité de la structure de paroi (100) en direction du centre de la structure de paroi (100).

5. Ensemble d'affichage selon la revendication 1, comprenant en outre:
un passage d'aération (140) pénétrant dans une surface de la structure de paroi (100), qui est en contact avec la couche adhésive (30), et une surface opposée de la structure de paroi(100), et ayant une forme courbée au moins une fois.

6. Ensemble d'affichage selon la revendication 5, dans lequel la structure de paroi (100) comprend une pluralité de structures de paroi (110, 120), et dans lequel le passage d'aération (140) est formé dans une partie d'accouplement entre la pluralité de structures de paroi (110, 120).

7. Ensemble d'affichage selon la revendication 1, dans lequel le couvercle (10) présente au moins une surface formée de manière à ce qu'elle soit incurvée ou plate, et
dans lequel une pluralité d'écrans (20) est disposée sur au moins une surface du couvercle (10).

8. Ensemble d'affichage selon la revendication 1, dans lequel la couche adhésive (30) est destinée à fixer l'écran (20) sur le couvercle (10) et est formée par le durcissement d'un matériau adhésif liquide, et
dans lequel la structure de paroi (100) est disposée sur le couvercle (10) entre une surface (12) sur laquelle l'écran (20) est disposé et un bord du couvercle (10), afin de former un espace dans lequel est logé le matériau adhésif liquide.

9. Ensemble d'affichage selon la revendication 8, dans lequel la structure de paroi (100) contient un matériau adhésif liquide qui s'écoule sur une partie de la structure de paroi (100) pendant le collage de l'écran (20).

10. Véhicule comprenant l'ensemble d'affichage selon l'une quelconque des revendications 1 ou 9.
